# EUROPÄISCHE PATENTSCHRIFT

(11) **EP 0 902 533 B1**
(45) Veröffentlichungstag und Bekanntmachung des Hinweises auf die Patenterteilung: **09.06.2004**
(21) Anmeldenummer: 98115413.1
(22) Anmeldetag: 14.08.1998
(51) Int. Cl.: H03F 3/45

(54) **Differenzverstärker**
Differential amplifier
Amplificateur différentiel

(30) Priorität: 11.09.1997 DE 19740000
(43) Veröffentlichungstag der Anmeldung: 17.03.1999
(73) Patentinhaber: Infineon Technologies AG, 81669 München (DE)
(72) Erfinder: Weber, Stephan, 81739 München (DE); Fenk, Josef, 85386 Eching (DE)
(74) Vertreter: Epping Hermann & Fischer

(56) Entgegenhaltungen:
- EP-A- 0 176 069
- US-A- 4 287 479
- US-A- 5 378 997
- US-A- 5 602 508

## Beschreibung

Die Erfindung betrifft einen Differenzverstärker mit Stromgegenkopplung, der zwei Transistoren, zwei mit den Steuereingängen der Transistoren verbundene Differenzverstärkereingänge, zwei mit den Ausgangskreisen der Transistoren verbundene Differenzverstärkerausgänge, wobei die Transistoren mit einem Bezugspotential gekoppelt sind, und zwei Induktivitäten aufweist, die einerseits mit den Transistoren verbunden sind und anderseits mit dem Bezugspotential gekoppelt sind.

Ein Differenzverstärker ist ein symmetrischer Gleichspannungsverstärker und zählt zu den Grundelementen in vielen elektronischen Schaltungen.

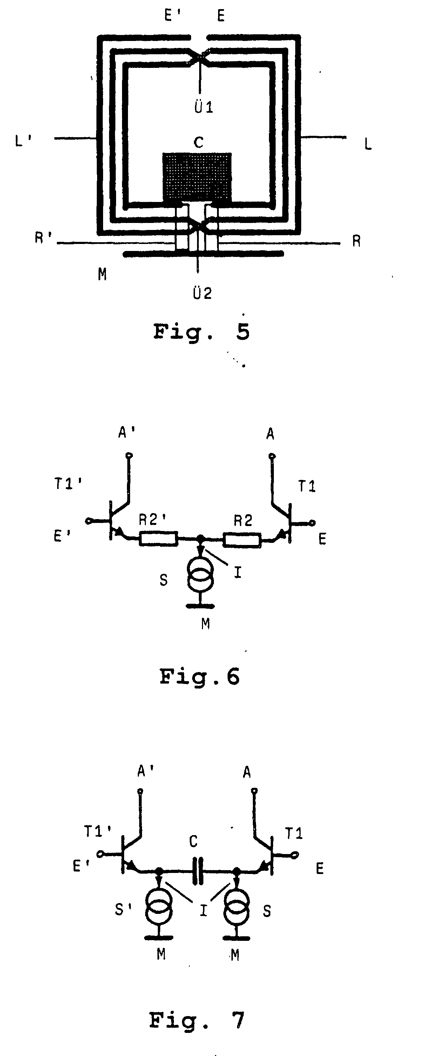

Ein erstes bekanntes Schaltungsprinzip eines Differenzverstärkers ist in Figur 6 gezeigt. Dieser weist einen ersten Transistor T1 und einen zweiten Transistor T1' auf, deren Basisanschlüsse mit den Differenzverstärkereingängen E bzw. E' verbunden sind. Die emittergekoppelten Transistoren T1 und T1' weisen in ihrem Emitterzweig die Widerstände R2 und R2' auf. Über eine Stromquelle S, die einerseits mit den beiden Widerständen R2 und R2' und andererseits mit einem Bezugspotential M verbunden ist, wird ein Strom I eingeprägt. Das differenzverstärkte Ausgangssignal ist an den Differenzverstärkerausgängen A und A', welche mit den Kollektoren der Transistoren T1 bzw. T1' verbunden sind, abgreifbar.

Die beiden Widerstände R2 und R2' dienen dazu, den kleinen linearen Eingangsspannungsbereich durch Stromgegenkopplung per Emitterwiderstand zu vergrößern. Dies hat jedoch den Nachteil, daß dadurch das Spannungsrauschen vergrößert und die Gleichtaktunterdrückung verschlechtert wird.

Auch eine Spannungsgegenkopplung (nicht gezeigt) würde die Gleichtaktunterdrückung verringern und das Stromrauschen vergrößern. Grundsätzlich ist von Nachteil, daß mit steigender Gegenkopplung der Spannungsversorgungsbedarf steigt.

Eine zweite Ausführungsform eines bekannten Differenzverstärkers ist in Figur 7 gezeigt. Der Differenzverstärker weist ebenfalls wie in Figur 6 die beiden Transistoren T1 und T1' sowie die beiden Differenzverstärkereingänge E und E' und die Differenzverstärkerausgänge A und A' auf, die mit den Transistoren T1 bzw. T1' verbunden sind. Im Emitterzweig der emittergekoppelten Transistoren T1 und T1' befindet sich eine Kapazität C. Die Emitteranschlüsse der Transistoren T1 und T1' sind jeweils zusätzlich mit einer Stromquelle S, S' verbunden.

Dadurch kann zwar erreicht werden, daß der Differenzverstärker ein besseres Rauschverhalten aufweist als der in Figur 6 gezeigte Differenzverstärker, aber die Gleichtaktunterdrükkung ist nach wie vor verbessernswert. Ein weiterer Nachteil der Schaltung gemäß Figur 7 zeigt sich in Stabilitätsproblemen durch die kapazitiv belasteten Emitter der Transistoren T1 und T1'. Auch steigt nachteilhafterweise mit zunehmender Gegenkopplung der Versorgungsstrombedarf.

US 5,378,997 beschreibt eine rauscharme Verstärkerstufe bestehend aus zwei Transistoren, deren Emitter über jeweils eine Induktivität mit einem Potentialpunkt verbunden sind.

Ferner beschreibt US 4,287,479 eine Verstärkerstufe eines Operationsverstärkers, die ein Paar rauscharmer Transistoren aufweist, die in einer Konfiguration mit einem gemeinsamen Emitter miteinander verschaltet sind. Dabei sind die Emitter der beiden Transistoren über jeweils eine Induktivität und einen Widerstand miteinander verbunden. Die beiden Induktivitäten werden durch separat aufgebaute Spulen gebildet.

Jedoch ist auch mit diesen bekannten Konfigurationen eine befriedigende Gleichtaktunterdrückung nicht möglich.

Der Erfindung liegt die Aufgabe zugrunde, einen Differenzverstärker zu schaffen, bei dem die Gleichtaktunterdrückung, die Linearität und das Rauschverhalten verbessert sind.

Die Aufgabe wird durch einen Differenzverstärker gemäß den Merkmalen des Patentanspruchs 1 gelöst. Vorteilhafte Weiterbildungen der Erfindung sind Gegenstand der abhängigen Ansprüche.

Der erfindungsgemäße Differenzverstärker weist dazu zwei Transistoren und zwei Differenzverstärkereingänge auf, die mit den Steuereingängen der Transistoren verbunden sind. Weiterhin sind zwei Induktivitäten vorgesehen, die einerseits mit den beiden Transistoren und andererseits mit einem Bezugspotential verbunden sind. Die Differenzverstärkerausgänge sind mit den Ausgangskreisen der Transistoren verbunden. Die Induktivitäten sind über einen Koppelkondensator miteinander verbunden.

Zur Verbesserung der Gleichtaktunterdrückung sind die beiden Induktivitäten vorzugsweise miteinander magnetisch gekoppelt.

Vorteilhafterweise sind die Werte der Induktivitäten gleich groß ausgeführt. Dadurch wird eine Symmetrie des Differenzverstärkers erreicht.

Die Transistoren können als Bipolartransistoren ausgeführt sein, wobei die Induktivitäten mit den Emitteranschlüssen der Transistoren verbunden sind. Alternativ können die Transistoren auch Feldeffekttransistoren sein, wobei dann die Induktivitäten mit den Sourceanschlüssen der Transistoren verbunden sind.

Vorzugsweise ist jeder Induktivitätszweig über eine Stromquelle mit dem Bezugspotential verbunden. Alternativ kann die Verbindung zum Bezugspotential über jeweils einen Widerstand hergestellt werden, wobei die Widerstände zweckmäßigerweise gleich sind.

Vorteilhafterweise wird durch den Koppelkondensator eine zusätzliche Bandpaßcharakteristik in den erfindungsgemäßen Differenzverstärker eingeführt und die DC-Offsetspannung vermindert oder unterdrückt.

Zusätzlich sind ein zweiter und ein dritter Widerstand vorgesehen, die einerseits mit je einem Steueranschluß der Transistoren und andererseits miteinander verbunden sind. Weiterhin ist ein Stromspiegel vorgesehen, der mit dem zweiten und dem dritten Widerstand verbunden ist. Dadurch ist vorteilhafterweise ein geringerer Betriebsspannungsbedarf erreichbar. Der zweite und der dritte Widerstand weisen zweckmäßigerweise den gleichen Widerstandswert auf.

Ferner können die Induktivitäten über jeweils einen Widerstand mit der entsprechenden Seite der Kapazität verbunden sein, wobei die Widerstände vorzugsweise den gleichen Widerstandswert aufweisen.

Die Erfindung wird anhand von den Figuren im folgenden näher erläutert.
Figur 1 zeigt einen Differenzverstärker,
Figur 2 zeigt einen weiteren Differenzverstärker,
Figur 3 zeigt eine Ausführungsform des erfindungsgemäßen Differenzverstärkers,
Figur 4 zeigt eine weitere Ausführungsform des erfindungsgemäßen Differenzverstärkers,
Figur 5 zeigt ein prinzipielles Schaltungslayout für die Spulen, Widerstände und den Koppelkondensator entsprechend der Ausführungsform der Figur 4,
Figur 6 zeigt eine erste Ausführungsform eines herkömmlichen Differenzverstärkers mit ohm'scher Gegenkopplung, und
Figur 7 zeigt eine zweite Ausführungsform eines herkömmlichen Differenzverstärkers mit kapazitiver Gegenkopplung.

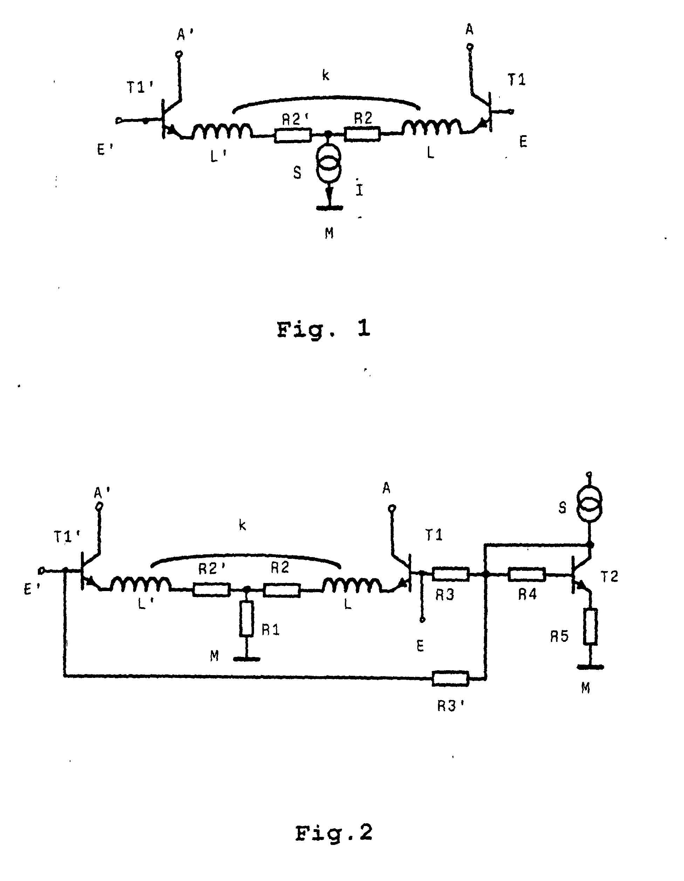

Auf die Differenzverstärker gemäß den Figuren 6 und 7 wurde bereits oben eingegangen. Auf die Differenzverstärker gemäß den Figuren 1 und 2 sind keine Patentansprüche gerichtet. De ren Erläuterung dient jedoch zum besseren Verständnis der be anspruchten Erfindung.

Der Differenzverstärker gemäß Figur 1 weist einen ersten und einen zweiten Transistor T1 und T1', die mit den Basisanschlüssen der Transistoren T1 und T1' verbundenen Eingangsar schlüsse des Differenzverstärkers E bzw. E' und die mit den Kollektoranschlüssen der Transistoren T1 und T1' verbundener Differenzverstärkerausgänge A bzw. A' auf. Weiterhin weist der Differenzverstärker eine erste und eine zweite Induktivi tät L und L' auf, die einerseits mit den Emitteranschlüssen der Transistoren T1 bzw. T1' und andererseits mit zwei Wider ständen R2 bzw. R2' verbunden sind. Die beiden Widerstände R und R2' sind über eine Stromquelle S mit dem Bezugspotential M verbunden. Die Stromquelle S prägt den Strom I ein. Die beiden Induktivitäten L und L' sind magnetisch mit dem Kopplungsfaktor k gekoppelt.

Die Signaleinspeisung erfolgt über die Differenzverstärkereingänge E und E'. Selbst wenn eine Eingangsseite des Dif ferenzverstärkers geerdet ist, erfolgt immer noch ein Signal stromfluß auch auf der geerdeten Seite, da die beiden Induktivitäten L und L' magnetisch miteinander gekoppelt sind. Dies führt zu einer höheren Gleichtaktunterdrückung.

Die Widerstände R2 und R2', die mit den Induktivitäten L bzw L' verbunden sind, können auch die Wicklungswiderstände der durch Spulen realisierten Induktivitäten L, L' sein. Durch die beiden Widerstände R2 und R2' ist das Rauschen minimierbar. Durch eine entsprechende Einstellung der Widerstandswerte der Widerstände R2 und R2' ist eine gemischte induktive-ohm'sche Gegenkopplung realisierbar. Der Differenzverstärker gemäß Figur 1 zeigt im Gegensatz zur einfachen kapazitiven Gegenkopplung gemäß Figur 7 gute Stabilitätseigenschaften.

Der Differenzverstärker gemäß Figur 2 unterscheidet sich von dem in Figur 1 gezeigten Differenzverstärker dadurch, daß die Stromquelle S durch einen Widerstand R1 sowie weitere Widerstände R3, R3', R4, R5, einen Transistor T2 und eine andere Stromquelle S ersetzt ist. Der Widerstand R1 ist zwischen die Widerstände R2, R2' und das Bezugspotential M geschaltet. Die Widerstände R3 und R3' sind einerseits mit den Basisanschlüssen der Transistoren T1 bzw. T1' und andererseits miteinander, dem Widerstand R4 sowie dem Kollektor des Transistors T2 verbunden. Der Widerstand R4 liegt zwischen den Widerständen R3, R3' und dem Basisanschluß des Transistors T2. Der Emitteranschluß des Transistors T2 ist über den Widerstand R5 mit dem Bezugspotential M verbunden. Die Stromquelle S ist auf den Kollektor des Transistors T2 geführt. Die Stromquelle S, die Widerstände R4 und R5 und der Transistor T2 bilden den Eingangszweig eines Stromspiegels.

Die Widerstände R3 und R3' dienen zur Vermeidung eines Kurzschlusses zwischen den Basisanschlüssen der Transistoren T1 und T1'. Aus Symmetriegründen wird jedem Basisanschluß der Transistoren T1 und T1' der Widerstand R3 bzw. R3' vorgeschaltet. Vorteilhafterweise sind die Widerstandswerte der Widerstände R3 und R3' gleich.

Die Arbeitspunkteinstellung erfolgt nun über den Stromspiegel, der die Transistoren T2, T1 und T1' umfaßt. Die Basisvorwiderstände R3 und R3' sorgen dafür, daß das Signal nicht unnötig abgeschwächt wird. Die Signaleinspeisung erfolgt an den Differenzverstärkereingängen E und E', die mit den Basisanschlüssen der Transistoren T1 bzw. T1' verbunden sind.

Selbst wenn eine Eingangsseite geerdet ist, erfolgt immer noch ein Signalstromfluß auch auf der geerdeten Seite, da die Induktivitäten L und L' magnetisch miteinander gekoppelt sind. Dies führt vorteilhafterweise zu einer erhöhten Gleichtaktunterdrückung.

Wie bei der in Figur 1 gezeigten Ausführungsform können auch bei der in Figur 2 gezeigten Ausführungsform die Widerstände R2 und R2' die Wicklungswiderstände der Spulen sein, durch die die Induktivitäten L und L' realisiert sein können. Durch eine geeignete Wahl der Widerstandswerte der Widerstände R2 und R2' ist das Rauschen minimierbar. Eine Vergrößerung der Widerstandswerte der Widerstände R2 und R2' bewirkt, daß eine gemischte induktive-ohm'sche Gegenkopplung erfolgt. Dieser Differenzverstärker zeigt im Gegensatz zum Differenzverstärker gemäß Figur 7 eine verbesserte Stabilität.

Selbst bei starker Gegenkopplung besteht bei der Schaltung gemäß Figur 2 nur ein geringer Betriebsspannungsbedarf. Aus Symmetriegründen weisen üblicherweise die beiden Widerstände R2 und R2' den gleichen Widerstandswert auf.

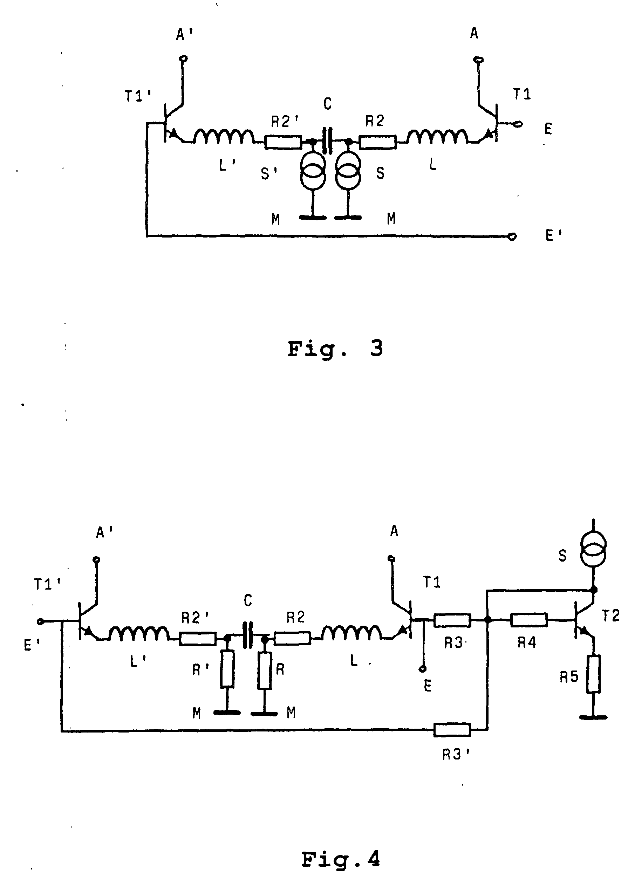

Figur 4 zeigt eine erste Ausführungsform des zweiten erfindungsgemäßen Differenzverstärkers. Hier werden die zwei mit Induktivitäten L, L' versehenen Emitterzweige der Transistoren T1 und T1' über eine Kapazität C, d.h. einen Koppelkondensator, miteinander verbunden. Die Verbindung zu dem Bezugspotential erfolgt über Widerstände R und R', wobei die Verbindung zu dem Bezugspotential M auf jeder Seite der Kapazität C erfolgt. Ein Stromspiegel bewirkt die Arbeitspunkteinstellung der Transistoren T1 und T1'. Zur Erläuterung des Stromspiegels wird auf die vorangegangene Beschreibung der Figur 2 verwiesen. Durch den Koppelkondensator C wird eine zusätzliche Selektion realisiert, eine Offsetspannung unterdrückt und ein niederfrequentes Rauschen reduziert.

Figur 3 zeigt eine zweite Ausführungsform des erfindungsgemäßen Differenzverstärkers, der im wesentlichen der Ausführungsform der Figur 4 entspricht. In dieser Ausführungsform sind die Widerstände, die die jeweiligen Emitterzweige der Transistoren T1 und T1' mit dem Bezugspotential M verbinden, durch jeweils eine Stromquelle S und S' ersetzt.

Ferner können auch in den Ausführungsformen gemäß der Figuren 3 und 4 die Widerstände in Serie zur Spule durch die Wicklungswiderstände der Spulen selbst ersetzt sein. Dies führt zu einer weiteren Minimierung des Rauschens. Ansonsten können die Widerstandswerte vergrößert werden, so daß sich eine gemischte induktive-kapazitive-ohmsche Gegenkopplung einstellt.

Die Schaltungen entsprechend den Figuren 3 und 4 zeigen im Gegensatz zur Schaltung gemäß der Figur 7 gute Stabilitätseigenschaften. Ferner besteht vorteilhafterweise selbst bei starker Gegenkopplung nur ein geringer Betriebsspannungsbedarf, wobei der Betriebsspannungsbedarf bei der konventionellen Stromeinspeisung über die zwei Stromquellen S, S' höher ist. Eine magnetische Kopplung der beiden Induktivitäten L und L' mit einem Kopplungsfaktor k ist in den Figuren 3 und 4 nicht dargestellt, da sie in der Ausführungsform nicht unbedingt notwendig ist, die magnetische Kopplung der Induktivitäten kann aber hier analog wie in den Ausführungsformen gemäß den Figuren 1 und 2 realisiert werden, was zu einer weiteren Verbesserung der Gleichtaktunterdrückung führt.

Figur 5 zeigt ein prinzipielles Layout für die Spulen, die Widerstände und den Koppelkondensator für die Ausführungsform des zweiten Differenzverstärkers gemäß Figur 4. Die dargestellt planare Doppelspule besteht aus zwei ineinander verschachtelten Spulen L und L', die durch die Überkreuzungen Ü1 und Ü2 völlig symmetrisch ausgebildet ist. Ferner wird durch die entstehende Gegeninduktivität ein gute Gleichtaktunterdrückung hergestellt. Die zwei Spulen L, L' sind durch den integrierten Kondensator C miteinander verbunden. Über Widerstände R und R' wird die Verbindung zum Bezugspotential M hergestellt. Die Spulen L, L' enden in jeweiligen Emitteranschlüssen E1 und E2. Durch die Überkreuzungen hat man bei einer 2-Lagen-Metallisierung keine Metallage für den Masseanschluß bzw. den Anschluß an das Bezugspotential M zur Verfügung. Dieser "Tunnel" kann aber ohne Probleme auch durch eine vorzugsweise niederohmige Widerstandsschicht realisiert werden.

### Bezugszeichenliste

- A: Verstärkerausgang
- A': Verstärkerausgang
- C: Koppelkondensator
- E: Verstärkereingang
- E': Verstärkereingang
- I: Strom
- k: magnetische Kopplung
- L: Induktivität
- L': Induktivität
- M: Bezugspotential
- R1: Widerstand
- R2: Widerstand
- R2': Widerstand
- R3: Widerstand
- R4: Widerstand
- R5: Widerstand
- S: Stromquelle
- S': Stromquelle
- T1: Transistor
- T1': Transistor
- T2: Transistor

## Patentansprüche

1. Differenzverstärker, der zwei Transistoren (T1, T1'), zwei mit den Steuereingängen der Transistoren (T1, T1') verbundene Differenzverstärkereingänge (E, E'), zwei mit den Ausgangskreisen der Transistoren (T1, T1') verbundene Differenzverstärkerausgänge (A, A'), wobei die Transistoren (T1, T1') mit einem Bezugspotential (M) gekoppelt sind, und zwei Induktivitäten (L, L') aufweist, die einerseits mit den Transistoren (T1, T1') verbunden sind und andererseits mit dem Bezugspotential (M) gekoppelt sind,
**dadurch gekennzeichnet, daß**
die Induktivitäten (L, L') über eine Kapazität (C) miteinander verbunden sind.

2. Differenzverstärker nach Anspruch 1, **dadurch gekennzeichnet, daß** die Werte der Induktivitäten (L, L') gleich sind.

3. Differenzverstärker nach Anspruch 1 oder 2, **dadurch gekennzeichnet, daß** die Transistoren (T1, T1') Bipolartransistoren sind und die Induktivitäten (L, L') mit den Emitteranschlüssen der Transistoren (T1, T1') verbunden sind.

4. Differenzverstärker nach Anspruch 1 oder 2,
**dadurch gekennzeichnet , daß** die Transistoren (T1, T1') Feldeffekttransistoren sind und die Induktivitäten (L, L') mit den Sourceanschlüssen der Transistoren (T1, T1') verbunden sind.

5. Differenzverstärker nach einem der Ansprüche 1 bis 4,
**dadurch gekennzeichnet, daß** die Induktivitäten (L, L') miteinander magnetisch gekoppelt sind.

6. Differenzverstärker nach einem der Ansprüche 1 bis 5,
**dadurch gekennzeichnet, daß** jeweils ein Widerstand (R2, R2') zwischen je eine der Spulen (L, L') und die Kapazität (C) geschaltet ist.

7. Differenzverstärker nach Anspruch 6,
**dadurch gekennzeichnet, daß** die Widerstände (R2, R2') den gleichen Widerstandswert aufweisen.

8. Differenzverstärker nach einem der Ansprüche 1 bis 7,
**dadurch gekennzeichnet, daß** jede Seite der Kapazität (C) über je eine Stromquelle (S, S') mit dem Bezugspotential (M) verbunden ist.

9. Differenzverstärker nach einem der Ansprüche 1 bis 8,
**dadurch gekennzeichnet , daß** der Differenzverstärker einen die Transistoren (T1, T1') umfassenden Stromspiegel aufweist.

10. Differenzverstärker nach Anspruch 9, **dadurch gekennzeichnet, daß** der Stromspiegel ferner aus Widerständen (R3, R3', R4, R5), einem weiteren Transistor (T2) und einer Stromquelle (S) besteht.

11. Differenzverstärker nach einem der Ansprüche 1 bis 10,
**dadurch gekennzeichnet, daß** jede Seite der Kapazität (C) über je einen weiteren Widerstand (R, R') mit dem Bezugspotential (M) verbunden ist und daß ein zweiter und ein dritter Widerstand (R3, R3') vorgesehen sind, die einerseits mit je einem Steueranschluß der Transistoren (T1, T1') und andererseits miteinander verbunden sind, und daß ein Stromspiegel (T2, R4, R5) vorgesehen ist, der mit dem zweiten und dem dritten Widerstand (R3, R3') verbunden ist.

12. Differenzverstärker nach Anspruch 11,
**dadurch gekennzeichnet, daß** der zweite und der dritte Widerstand (R3, R3') den gleichen Widerstandswert aufweisen.

## Claims

1. Differential amplifier having two transistors (T1, T1') , two differential amplifier inputs (E, E') connected to the control inputs of the transistors (T1, T1') , two differential amplifier outputs (A, A') connected to the output circuits of the transistors (T1, T1'), the transistors (T1, T1') being coupled to a reference potential (M), and two inductances (L, L'), which, on the one hand, are connected to the transistors (T1, T1') and, on the other hand, are coupled to the reference potential (M),
**characterized in that**
the inductances (L, L') are connected to one another via a capacitance (C).

2. Differential amplifier according to Claim 1, **characterized in that** the values of the inductances (L, L') are identical.

3. Differential amplifier according to Claim 1 or 2, **characterized in that** the transistors (T1, T1') are bipolar transistors and the inductances (L, L') are connected to the emitter terminals of the transistors (T1, T1').

4. Differential amplifier according to Claim 1 or 2, **characterized in that** the transistors (T1, T1') are field-effect transistors and the inductances (L, L') are connected to the source terminals of the transistors (T1, T1') .

5. Differential amplifier according to one of Claims 1 to 4, **characterized in that** the inductances (L, L') are magnetically coupled to one another.

6. Differential amplifier according to one of Claims 1 to 5, **characterized in that** a respective resistor (R2, R2') is connected between a respective one of the coils (L, L') and the capacitance (C).

7. Differential amplifier according to Claim 6, **characterized in that** the resistors (R2, R2') have the same resistance.

8. Differential amplifier according to one of Claims 1 to 7, **characterized in that** each side of the capacitance (C) is connected via a respective current source (S, S') to the reference potential (M).

9. Differential amplifier according to one of Claims 1 to 8, **characterized in that** the differential amplifier has a current mirror comprising the transistors (T1, T1').

10. Differential amplifier according to Claim 9, **characterized in that** the current mirror furthermore comprises resistors (R3, R3', R4, R5), a further transistor (T2) and a current source (S).

11. Differential amplifier according to one of Claims 1 to 10, **characterized in that** each side of the capacitance (C) is connected via a respective further resistor (R, R') to the reference potential (M) and **in that** a second and a third resistor (R3, R3') are provided, which are connected to a respective control terminal of the transistors (T1, T1'), on the one hand, and to one another, on the other hand, and **in that** a current mirror (T2, R4, R5) is provided which is connected to the second and third resistors (R3, R3').

12. Differential amplifier according to Claim 11, **characterized in that** the second and third resistors (R3, R3') have the same resistance.

## Revendications

1. Amplificateur différentiel qui a deux transistors (T1, T1'), deux entrées (E, E') d'amplificateur différentiel reliées aux entrées de commande des transistors (T1, T1') deux sorties (A, A') d'amplificateur différentiel reliées aux circuits de sortie des transistors (T1, T1') les transistors (T1, T1') étant couplés à un potentiel (M) de référence et deux inductances (L, L') qui sont reliées d'une part aux transistors (T1, T1') et qui sont couplés d'autre part au potentiel (M) de référence.
**caractérisé en ce que** les inductances (L, L') sont reliées entre elles par une capacité (C).

2. Amplificateur différentiel suivant la revendication 1, **caractérisé en ce que** les inductances (L, L') ont la même valeur.

3. Amplificateur différentiel suivant la revendication 1 ou 2, **caractérisé en ce que** les transistors (T1, T1') sont des transistors bipolaires, et les inductances (L, L') sont reliées aux bornes d'émetteur des transistors (T1, T1').

4. Amplificateur différentiel suivant la revendication 1 ou 2, **caractérisé en ce que** les transistors (T1, T1') sont des transistors à effet de champs et les inductances (L, L') sont reliées aux bornes de source des transistors (T1, T1').

5. Amplificateur différentiel suivant les revendications 1 à 4, **caractérisé en ce que** les inductances (L,L') sont couplées magnétiquement entres elles.

6. Amplificateur différentiel suivant les revendications 1 à 5, **caractérisé en ce qu'**une résistance (R2, R2') est montée respectivement entre l'une des bobines (L, L') et la capacité (C).

7. Amplificateur différentiel suivant la revendication 6, **caractérisé en ce que** les résistances (R2, R2') ont la même valeur.

8. Amplificateur différentiel suivant l'une des revendications 1 à 7, **caractérisé en ce que** chaque côté de la capacité (C) est reliées par respectivement une source (S, S') de courant au potentiel (M) de référence.

9. Amplificateur différentiel suivant l'une des revendications 1 à 8, **caractérisé en ce que** l'amplificateur différentiel a un miroir de courant comprenant les transistors (T1, T1').

10. Amplificateur différentiel suivant la revendication 9, **caractérisé en ce que** le miroir de courant est constitué en outre de résistances (R3, R3', R4, R5), d'un autre transistor (T2), et d'une source (S), de courant.

11. Amplificateur différentiel suivant l'une des revendications 1 à 10, caractérisé en chaque côté de la capacité (C) est relié, par respectivement une autre résistance (R, R') au potentiel (M) de référence et il est prévu une deuxième et une troisième résistances (R3, R3') qui sont reliées d'une part respectivement à une borne de commande des transistors (T1, T1'), et d'autre part entre elles et il est prévu un miroir (T2, R4, R5) de courant qui est relié à la deuxième et la troisième résistances (R3, R3').

12. Amplificateur différentiel suivant la revendication 11, **caractérisé en ce que** la deuxième et la troisième résistances (R3, R3') ont la même valeur.
